(19) Europäisches Patentamt

European Patent Office

Office européen des brevets

(11) **EP 1 054 509 A2**

(12) **EUROPEAN PATENT APPLICATION**

(43) Date of publication:
**22.11.2000 Bulletin 2000/47**

(51) Int. Cl.[7]: **H03H 17/02**

(21) Application number: **00201737.4**

(22) Date of filing: **16.05.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **19.05.1999 IT MI991102**

(71) Applicant:
**Telit Mobile Terminals S.p.A.**
**34010 Sgonico (Trieste) (IT)**

(72) Inventors:
• **Benvenuto, Nevio**
  **31021 Mogliano Veneto (Treviso) (IT)**
• **Mian, Gian Antonio**
  **35100 Padova (IT)**
• **Momola, Fabio**
  **31100 Treviso (IT)**

(74) Representative:
**Faraggiana, Vittorio, Dr. Ing.**
**Ingg. Guzzi & Ravizza S.r.l.**
**Via Vincenzo Monti 8**
**20123 Milano (IT)**

(54) **Multistandard reception apparatus with cascaded multistage-structured numerical filters**

(57) A multistandard receiver in which a received and digitized signal is applied to the input of a digital filtering section having outputs from which can be taken signals corresponding to predetermined transmission standards and contents in the received signal. The filtering section comprises a cascaded multistage filter structure and at selected points along the cascade are connected additional shunt filters whose outputs are the above mentioned outputs for taking signals corresponding to the predetermined transmission standards.

Fig.1

EP 1 054 509 A2

**Description**

The present invention relates to a multistandard reception apparatus.

More particularly it relates to a reception apparatus in which signal filtering for channel selection and frequency adaptation is achieved by means of numerical filters with an innovative cascaded multistage structure designed for multistandard use and software definable.

Radio terminals termed 'multistandard', i.e. capable of operating in accordance with a broad variety of different mobile radio communication standards, are extremely interesting. In the mobile radio field this is particularly true because of the emergence of new wide-band standards which take their place, at least initially, beside standards already in use, making it desirable to supply mobile apparatuses allowing operation either with the most widespread standard or the emerging standard.

For example, in the European area the emergence of wide-band standards such as DECT should be accompanied by some degree of compatibility with the well known on GSM/DCS-based systems.

Software-defined multistandard terminals capable of operating in accordance with a broad variety of mobile radio communication standards are an extremely powerful tool for evolution toward a future third generation of cellular systems.

The high computation complexity of software filters and hence of filters defined by software or conventional software-defined receivers is known. If it is desired to produce a conventional software-defined receiver designed for operating with several standards the prior art suggests integration in a single apparatus of several complete one-standard receivers in a single apparatus. But this involves such a high computation load as to make the solution practically unusable, especially if it is desired to implement a certain number of standards in an apparatus with limited weight and cost such as commercial mobile radio terminals must be.

The general purpose of the present invention is to remedy the above mentioned shortcomings by making available an innovative multistandard receiver structure allowing software-defined production with reduced computation cost even for a relatively high number of implemented standards.

In view of this purpose it was sought to provide in accordance with the present invention a multistandard receiver in which a received and digitized signal is applied to the input of a digital filtering section having outputs from which can be taken signals corresponding to predetermined transmission standards and contents in the received signal with the filtering section comprising a cascaded multistage filter structure with connected at points along the cascade additional shunt filters whose outputs are the above mentioned outputs for taking signals corresponding to the predetermined transmission standards with the total transfer function from the input to an output corresponding to the transfer function required by the corresponding standard.

To clarify the explanation of the innovative principles of the present invention and its advantages compared with the prior art there is described below with the aid of the annexed drawings a possible embodiment thereof by way of non-limiting example applying said principles. In the drawings:

FIG 1 shows a block diagram of the structure of a software-defined receiver,
FIG 2 shows an innovative structure of the digital filtering section provided in accordance with the present invention,
FIG 3 shows an embodiment of the first stages of the structure of FIG 2, and
FIG 4 shows an explanatory graph for selection of the filter transition band of FIG 2.

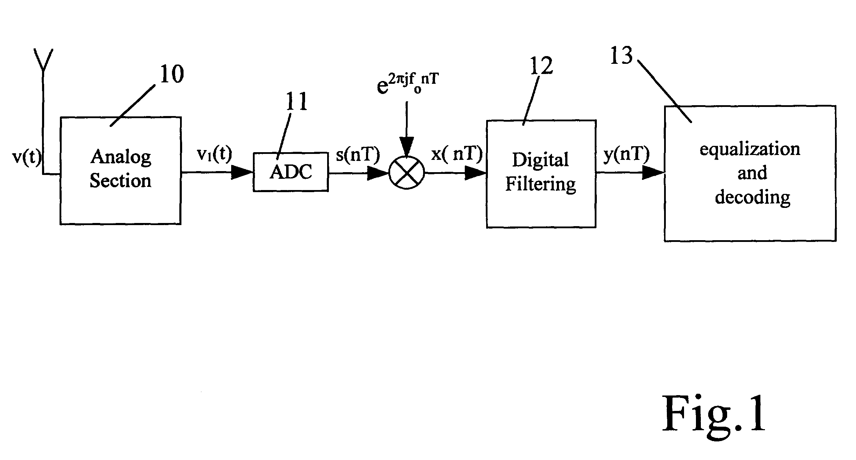

With reference to the FIGS FIG 1 shows the structure of a software-defined reception apparatus whose functional blocks are an analog section 10, an analog/digital interface section (ADC) 11, a digital filtering section 12 and an equalization and decoding section 13.

The analog section 10 receives the signal v(t) from the antenna and is used to select the band in which the signal of interest is contained and returns this signal $v_1(t)$ at the next ADC section appropriately amplified. The analog/digital interface receives the analog signal $v_1(t)$ and supplies a wide-band radio signal s(nT) digitized at a predetermined frequency F=1/T . The digital filtering section is used to select the channel of interest and adapt the sampling frequency to the one imposed by the standard. The signal y(nT) obtained from the filtering section output is sent to the equalization and decoding section 13.

The section which with multistandard receivers requires in accordance with the prior art an excessively high computation power is the digital filtering section 12 and it is this section which we shall discuss principally below. The other receiver sections are virtually prior art and accordingly readily imaginable by one skilled in the art and for this reason will not be further described nor shown in detail.

The innovative structure of a filtering section in accordance with the present invention is described below with reference to an exemplary case in which it is desired to filter the standards listed in the following table 1.

Table 1

| PARAMETERS | DECT | IS-95 | UDPC | GSM | IS-54 |
|---|---|---|---|---|---|
| Fp(kHz) | 576 | 614 | 125 | 100 | 12 |
| Fs(kHz) | 1728 | 1250 | 350 | 200 | 30 |

Fp is the pass-band cut-off frequency and Fs is the attenuated band cut-off frequency. These standards are chosen here because they are a sufficiently significant sample since sufficiently broad and varied but the innovative structure of the present invention is adaptable to any other type of standard. The choice made is to be considered purely as a non-limiting example of the present invention.

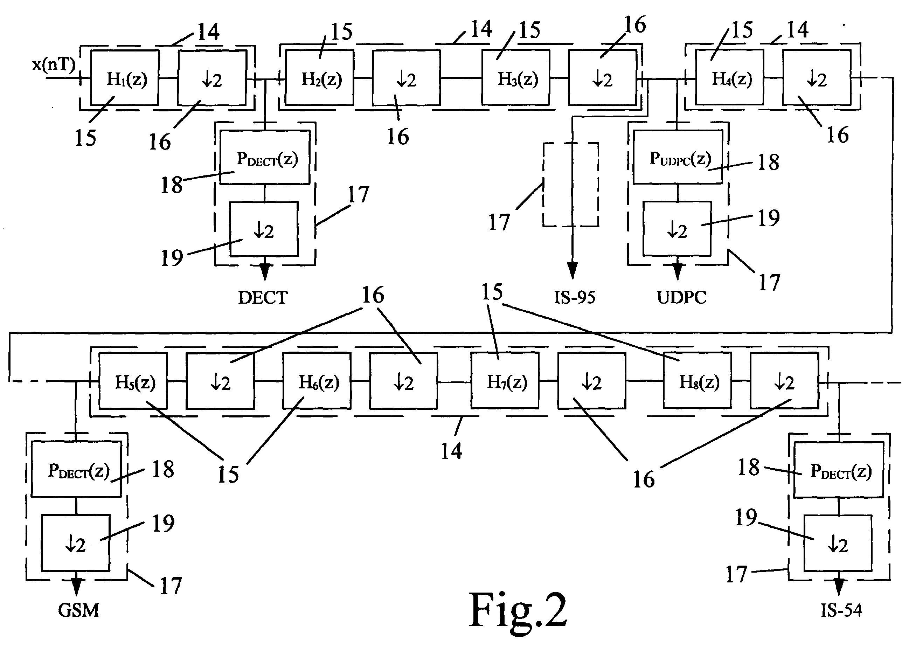

As may be seen in FIG 2, at the digital filtering section input the digitized radio signal enters from the interface block A/D which will have to ensure sufficiently high dynamics to represent the signal optimally.

In accordance with the present invention the filtering section comprises a cascaded multistage structure made up of filtering and decimation blocks 14 arranged in cascade to form a main cascade. From among the filtering and decimation blocks 14 are taken the signals to be sent to appropriate additional filtering and decimation blocks 17 to shunt the typical signals of the standards from the main cascade to it's own DECT, IS-95, UDPC, GSM or IS-54 output.

Each path from the input of the signal X(nT) to an output point of the signal developed for a predetermined standard (DECT, IS-95, UDPC, GSM, IS-54) has overall the function of transfer H(f) typical of that standard. It can be noted than if the appropriate transfer function for a certain standard is obtained directly along a section of the main cascade the related block 17 will have a unitary transfer function. This can be seen in FIG 2 for the IS-95 standard.

Insertion of a new standard means merely taking the corresponding signal at an appropriate point on the cascade.

The filtering and decimation blocks of the main cascade are made up of filters 15 with each one followed by a decimation block 16 which configures the filter as a decimator. Similarly the shunt decimation and filtering or 'post-filter' blocks 17 are made up of filters 18 each followed by a decimation block 19.

With such a structure a polyphase embodiment allowing computation cost reduction is possible.

As an example, the filters contained in the filtering and decimation blocks can be FIR. The filter characteristics are chosen so as to minimize the order.

The structure displays flexibility characteristics ensuring the possibility of replacement of the FIR filters with any other filter type (IIR, null phase IIR, etc).

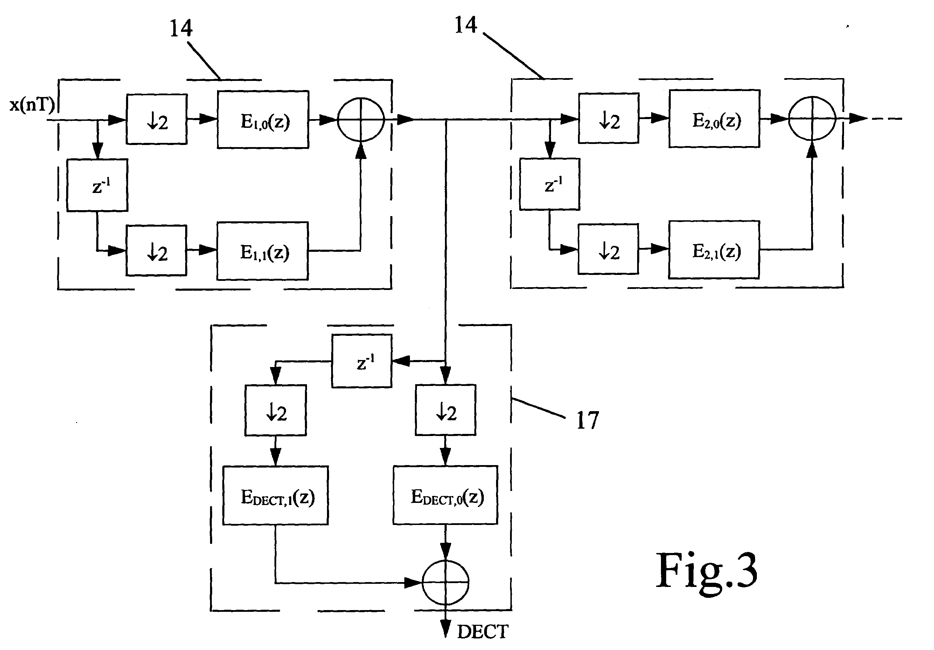

The diagram obtained is represented for the first stages of the cascade in FIG 3 where $E_{x,i}(z)$ indicates the $i^{th}$ polyphase component of the filter. The block diagram of FIG 3 is self-explanatory for one skilled in the art.

Structure optimization is obtained with three strategies, to wit:

1. apportionment of the pass-band error to have a high ripple for the first stages and low for the last but ensuring for each output channel an error lower than a certain preset threshold, e.g. 0.2dB,
2. optimized apportionment of extraband attenuation ensuring for each output point total attenuation not lower than a preset value, e.g. 80dB, and
3. appropriate choice of the transition band for each filter.

The choice of the pass-band error apportionment from among the various filters is crucially important for resulting filter order reduction. It is noted that the pass-band error is added in the various stages where the pass-bands are superimposed. As from the computation viewpoint the critical stages are the early ones, in which work is done at higher frequency, to ensure the structure low computation complexity it is necessary to allow the highest error allowed in the early stages to obtain low orders for the early filters. Consequently the following filters will be of higher order but the working frequency will have been lowered by decimation.

In accordance with the present invention the pass-band error of the $i^{th}$ stage can be set in accordance with the fdollowing law:

$$\delta_{p,i} = \delta_p / 2^{\,i}$$

where the denominator is the total decimation factor with respect to the initial signal.

As to choice of the attenuated band error the signal to aliasing noise ratio is defined as:

$$SNR = P_{signal}/P_{noise}$$

It is shown that for SRN the following relationship applies:

$$SNR \geq -\log_{10}(M-1)\delta^2_s$$

M is known since it depends on the type of channel for which the calculation is done. With SRN set at the predetermined value it is sought to ensure as minimal at every output point (e.g. advantageously 80dB), $\delta_s$ is found.

It is observed that for the filter H(f) to have a ripple desired $\delta_s$, it is necessary theoretically to ensure that all the filters contributing to make up F(f) have the same $\delta_s$.

Lastly, choice of the transition band of each filter is surely the most delicate point in the design stage. To reduce the order of the filter it is indispensable to increase its transition band. The algorithm which maximizes the width of $\Delta f$ must allow for the aliasing introduced with the next decimation. For the purpose of solving the proposed problem it is unnecessary to totally avoid aliasing; it suffices to make sure that it does not appear in the useful band of the channels it is sought to isolate.

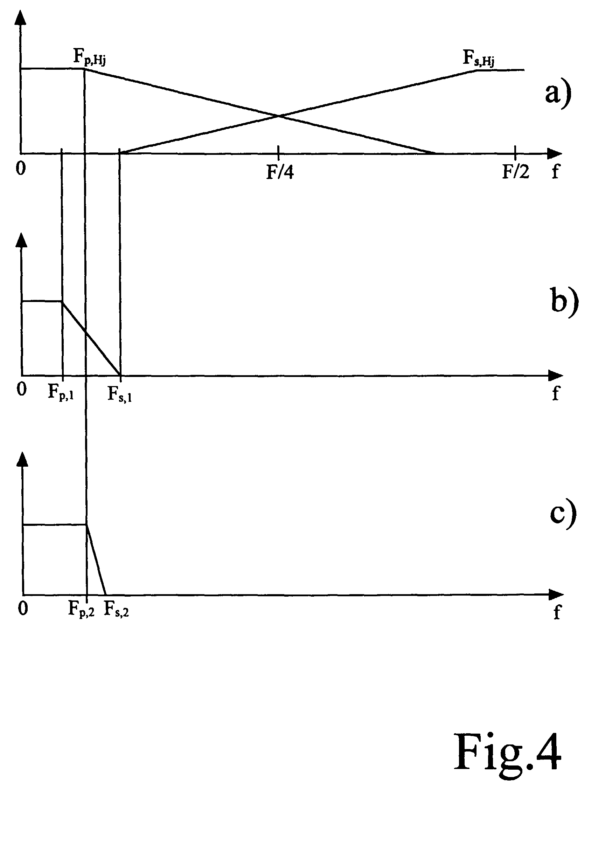

With reference to the multistage structure of FIG 2 the choice criterion adopted is shown graphically in FIG 4.

Let $F_{p,i}$ and $F_{s,i}$, $1 \leq$ the $\leq U$ be the characteristic frequencies of the standard U. In the design of the filter $H_j$ of the main cascade the following relationships for the choice of $F_{p,Hj}$ and $F_{s,Hj}$ apply.

$$F_{p,Hj} = \max(F_{p,i}) \qquad j \leq \text{ the } \leq U$$

$$F_{s,Hj} = \max(f|(F/2-f) \geq F_{s,i}) \qquad j \leq \text{ the } \leq U$$

It is noted that it is not enough to look only at the first of the following channels since it is not generally true that $F_{p,Hi} = F_{s,j}$ and $F_{s,Hj} = F_{s,j}$. An example is given in FIG 4 where at a) is shown the necessary choice of the transition band due at channel 1 (which is a DECT channel) with band shown at b) and at channel 2 (which is an IS-95 channel) with band shown at c). The corresponding values of $F_p$ and $F_s$ are shown in Table 1.

It is now clear that the predetermined purposes have been achieved. The prior art solutions for the channel selection section and for adaptation of the frequency always display the same structure i.e. they consist of a separate decimator filter for each standard considered. All these solutions differ only by the embodiment adopted for the decimator filter. The use in accordance with the present invention of a multistage structure, i.e. allowing multistage processing of the signal, is totally innovative as compared with the conventional structures. With it it is possible to select any type of standard by facing the problem in a modular manner, which allows, e.g. introduction of new channel types with minimal designing effort.

The structure in accordance with the present invention allows filtering of any channel type through appropriate choice of the post-filter insertion points. In addition it is characterized by extreme modularity allowing introduction of any channel type and, once the standards have been chosen, optimization of the filters by application of the above mentioned criteria. The innovative structure is also characterized by extreme flexibility since it allows the use of any digital filter type and in particular FIR filters (if necessary even COMBI), IIR, or null phase IIR.

The computation complexity is approximately the same for each output channel regardless of its position in the main cascade.

Naturally the above description of an embodiment applying the innovative principles of the present invention is given by way of non-limiting example of said principles within the scope of the exclusive right claimed here. As mentioned above, the standards indicated are only given by way of example with the structure proposed here being readily expandable and/or changeable to allow handling any type of standard. To do this it suffices to choose the insertion point in the main cascade of the post-filter and design the post-filter in accordance with the optimization criteria explained above.

**Claims**

1. Multistandard receiver in which a received and digitized signal is applied to the input of a digital filtering section having outputs from which can be taken signals corresponding to predetermined transmission standards and contents in the received signal with the filtering section comprising a cascaded multistage filter structure with connected at points along the cascade additional shunt filters whose outputs are the above mentioned outputs for taking signals corresponding to the predetermined transmission standards with the total transfer function from the input to an output corresponding to the transfer function required by the corresponding standard.

2. Receiver in accordance with claim 1 characterized in that each filter and post-filter is followed by a decimation block with the filter and decimation block assembly forming a decimator with polyphase structure.

3. Receiver in accordance with claim 1 characterized in that each filter is chosen for apportioning the pass-band error among the filters so that the pass-band error of the $i^{th}$ stage will be:

$$\delta_{p,i} = \delta_p / 2^i$$

where the denominator is the total decimation factor with respect to the initial signal.

4. Receiver in accordance with claim 1 characterized in that each filter of the cascade is chosen to apportion the attenuated band error so that the following relationship prevails:

$$SNR \geq -\log_{10}(M-1)\delta^2_s$$

with SNR equal to the preset value it is desired to ensure as minimal at each output.

5. Receiver in accordance with claim 1 characterized in that for each filter of the main cascade the following relationships apply:

$$F_{p,Hj} = \max(F_{p,i}) \qquad j \leq \text{the} \leq U$$

$$F_{s,Hj} = \max(f|(F/2-f) \geq F_{s,i}) \qquad j \leq \text{the} \leq U$$

where $F_{p,i}$ and $F_{s,i}$, $1 \leq \text{the} \leq U$ are the characteristic frequencies of the standard U and $F_{p,Hj}$ and $F_{s,Hj}$ refer to the $j^{th}$ filter of the main cascade.

$$v(t) \rightarrow \boxed{\begin{array}{c}\text{Analog} \\ \text{Section}\end{array}}^{10} \xrightarrow{v_1(t)} \boxed{\text{ADC}}^{11} \xrightarrow{s(nT)} \otimes \xrightarrow{x(nT)} \boxed{\begin{array}{c}\text{Digital} \\ \text{Filtering}\end{array}}^{12} \xrightarrow{y(nT)} \boxed{\begin{array}{c}\text{equalization} \\ \text{and} \\ \text{decoding}\end{array}}^{13}$$

$e^{2\pi j f_o nT}$

Fig.1

EP 1 054 509 A2

Fig.2

Fig.3

EP 1 054 509 A2

Fig.4